# EUROPEAN PATENT SPECIFICATION

(11) **EP 0 791 663 B1**
(45) Date of publication and mention of the grant of the patent: **10.01.2001**
(21) Application number: 97301256.0
(22) Date of filing: 26.02.1997
(51) Int. Cl.: C23C 14/06, H01L 21/285

(54) **Titanium nitride barrier layers**
Barriereschichten aus Titannitrid
Couches barrières à base de nitrure de titane

(30) Priority: 26.02.1996 US 606623; 26.02.1996 US 595446
(43) Date of publication of application: 27.08.1997
(60) Divisional application: 00106422.9
(73) Proprietor: APPLIED MATERIALS, INC., Santa Clara, California 95052 (US)
(72) Inventor: Fu. Jianming, San Jose, California 95124 (US); Chen, Fusen, Cupertino, California 95014 (US); Xu, Zheng, Foster City, California 94404 (US)
(74) Representative: Allard, Susan Joyce

(56) References cited:
- EP-A- 0 680 077
- EP-A- 0 747 499
- EP-A- 0 747 500
- PROCEEDINGS OF THE 29TH NATIONAL SYMPOSIUM OF THE AMERICAN VACUUM SOCIETY, BALTIMORE, MD, USA, 16-19 NOV. 1982, vol. 1, no. 2, pt.1, ISSN 0734-2101, JOURNAL OF VACUUM SCIENCE & TECHNOLOGY A (VACUUM, SURFACES, AND FILMS), APRIL-JUNE 1983, USA, pages 352-355, XP000675760 BRETT M J ET AL: "High rate planar magnetron deposition of transparent, conducting, and heat reflecting films on glass and plastic"
- APPLIED PHYSICS LETTERS, vol. 62, no. 4, 25 January 1993, pages 357-359, XP000335994 DIXIT G A ET AL: "REACTIVELY SPUTTERED TITANIUM NITRIDE FILMS FOR SUBMICRON CONTACT BARRIER METALLIZATION"
- PATENT ABSTRACTS OF JAPAN vol. 017, no. 597 (C-1127), 2 November 1993 & JP 05 179435 A (TOSOH CORP), 20 July 1993,
- PATENT ABSTRACTS OF JAPAN vol. 015, no. 070 (E-1035), 19 February 1991 & JP 02 291124 A (FUJITSU LTD), 30 November 1990,

## Description

This invention relates to improved titanium nitride barrier layers and to a process for making them. More particularly, this invention relates to improved titanium nitride barrier layers that prevent spiking by overlying contact layers.

Titanium nitride is a known barrier material used to prevent spiking of metal contacts, such as aluminum, into a silicon substrate. When aluminum is used as a contact material over a silicon substrate, subsequent heat treatment results in interdiffusion between the aluminum and the silicon, forming a conductive path between them that can short out devices. Titanium nitride is used as a barrier between aluminum and silicon.

The titanium nitride can be deposited in two modes; 1) the so-called poisoned mode, in which the titanium target is nitrided and titanium nitride is sputtered from the target; or 2) the metallic mode, in which the target is maintained as metallic titanium, and the titanium is sputtered from the target and reacts with nitrogen on the substrate surface, forming a titanium nitride film on the substrate. The poison mode titanium nitride is not as dense as the metallic mode titanium nitride, and thus requires additional treatment. Sputtered titanium nitride forms a crystalline material, and spiking can still occur between the interstices of the crystals. When oxygen is adsorbed onto TiN, it fills these interstices, which is known as "stuffing" the titanium nitride. This stuffing has been done traditionally by using a furnace anneal, or a heat treatment in a rapid thermal anneal (RTA) chamber in an oxygen-containing atmosphere. While this treatment reduces the spiking problem, both a sputtering chamber and an RTA chamber must be provided, and a break in the vacuum after sputtering the titanium nitride layers to perform the oxygen exposure and RTA steps is required prior to sputter deposition of the overlying aluminum contact.

The adhesion of titanium nitride to silicon has also been improved by sputter depositing a first thin layer of titanium alone in the contact opening. This titanium layer can react with a silicon substrate to form titanium silicide, reducing the resistance of the contact.

A final thin layer of titanium can also be deposited as a wetting layer over the titanium nitride to improve adhesion of the TiN layer to an overlying aluminum contact layer.

The deposition of these titanium-containing layers and the oxygen stuffing of the titanium nitride layer can all be carried out in a single sputtering chamber. A titanium target and an inert gas, such as argon, is used to sputter deposit the first layer of titanium; nitrogen gas is added to the chamber and sputtering is continued to form a titanium nitride layer. The oxygen stuffing treatment can be performed in the same chamber by flowing a mixture of oxygen and an inert gas and applying DC power to the target after the titanium nitride deposition.

Oxygen stuffing of the titanium layer of a Ti/TiN stack can be used as a barrier layer when titanium nitride is sputter deposited in the metallic mode sputtering method. However, when the titanium nitride is deposited in the poison mode method, the results are less than satisfactory and spiking of an overlying aluminum layer still occurs.

Thus the search for an improved process and improved contacts has continued.

EP-A-0747499 relates to a process for the deposition of titanium/titanium nitride barrier layers prior to aluminium contact deposition. EP-A-0747499 discloses oxygenating a sputtered titanium layer, but does not disclose oxygenating both the sputtered titanium layer and a sputtered titanium nitride layer.

We have found that improved barrier layers can be deposited in a single sputtering chamber by sequentially sputter depositing a first titanium layer, oxidizing this titanium layer, and sputter depositing a titanium nitride layer. The titanium nitride layer is also oxidized to further improve the barrier layer properties, and optionally an overlying titanium wetting layer can also be deposited over the TiN layer or layers, all in the same chamber.

The oxidized titanium layer can be formed by post treatment of the titanium layer using an oxygen plasma; or by sputtering a titanium target in the presence of oxygen or a mixture of oxygen and nitrogen, or both, to form a thin TiO₂ or a TiON layer over the titanium layer. The deposited TiN layer is also oxidized after sputter deposition. Deposition of an aluminum layer thereover completes the formation of an aluminum contact. Thus the spiking problem is addressed without exposing the substrate to air or removing from a vacuum environment.

Accordingly, the present invention provides A process for depositing a titanium/titanium nitride barrier layer in a sputtering chamber fitted with a source of RF power connected to a substrate support, the process comprising:
a) sputter depositing a titanium layer onto the exposed surface of a substrate;
b) oxygenating the titanium layer by treatment with an oxygen-containing plasma in the chamber;
c) sputter depositing a titanium nitride layer over the titanium-oxygen-containing layer; and
d) oxygenating the titanium nitride layer by treatment with an oxygen-containing plasma in the chamber.

Fig. 1 is a cross sectional view of a sputtering chamber in which the present process can be carried out.

Fig. 2 is a photomicrograph of contacts made in accordance with one embodiment of the present process.

Fig. 3 is a photomicrograph of contacts made in accordance with a prior art process.

Fig. 4 is a photomicrograph of contacts made in accordance with another prior art process.

Fig. 5 is a photomicrograph of contacts made in accordance with still another prior art process.

Fig. 6 is an SEM photomicrograph of a heat treated aluminum contact of the present invention.

Fig. 7 is an SEM photomicrograph of a heat treated aluminum contact of the prior art.

Fig. 8 is an SEM photomicrograph of another embodiment of a heat treated aluminum contact of the prior art.

Fig. 9 is a cross sectional schematic view of a multichamber vacuum system for carrying out sequential processing steps without breaking vacuum.

Fig. 10 is a cross sectional schematic view of a system for making stuffed titanium nitride barrier layers.

In accordance with the process of the invention, a first titanium layer is sputter deposited in argon onto a substrate having openings therein for the deposit of aluminum contacts. A sputtering chamber fitted with a DC power source connected to a titanium target is used. This titanium layer is generally deposited at a high DC power of 10,000-12,000 watts with a negative potential applied to the target, and the chamber wall grounded, so that formation of a plasma from argon or other gas is formed in the chamber. In accordance with the invention, titanium is deposited at a deposition rate of about 1000Å/min. Oxygenated Ti can be formed in several ways. In accordance with one embodiment of the invention, a source of RF power (generally 13.56 MHz) is connected to the substrate support, and, after deposition of the Ti layer, an oxygen-containing gas, such as mixtures of oxygen and argon that can also contain nitrogen, is flowed into the chamber and the RF power is turned on to create a plasma of the plasma precursor gases in the sputtering chamber. Using RF power of 100-200 watts, the typical DC bias developed on the substrate support is about - 100V to -200V.

In another embodiment, after sputter deposition of the Ti Layer, an oxygen-containing gas, such as mixtures of oxygen and argon that can also contain nitrogen, is flowed into the chamber and both the DC and the RF power sources are turned on to create a plasma of the gases in the sputtering chamber. The generated oxygen plasma will form a layer of TiOₓ, or TiOₓN_{y} when nitrogen is added.

In a third embodiment, in addition to the RF power applied, a low DC power of about 500 watts is also applied to the target. The titanium is sputtered in the presence of an oxygen plasma at a low deposition rate. This also forms a thin (about 20Å thick) titanium oxide or titanium oxynitride layer over the first titanium layer.

In still another embodiment, the third embodiment is followed except that no RF power is applied. This process also forms a thin layer of titanium oxide or titanium oxynitride over the first titanium layer.

Thus the plasma deposition process is controlled by adjusting the DC and RF power supplies, and by adjusting the gas flows and gas flow rates.

Oxygen ions and atoms generated in the plasma are more reactive than oxygen molecules, and they diffuse or penetrate into the grain boundaries of the deposited titanium on the substrate more rapidly than oxygen molecules. By adjusting the gas flows and gas flow rates, and by adjusting both the DC and RF power supplies, a desired oxygenated layer of titanium is formed on the substrate over the titanium layer.

The oxygen plasma is discontinued when an oxide layer up to about 20Å in thickness is formed. This thin oxide layer does not adversely affect the resistance of the titanium nitride layer or the resistance of the aluminum contact but does improve the robustness of the barrier layer.

The process is continued by shutting off the RF power and continuing to deposit titanium nitride using DC bias to the target by sputtering titanium in the presence of nitrogen, generally nitrogen and argon, in known manner.

Oxygen is passed again into the chamber and both the DC and the RF power to the substrate support are turned on to form an oxygen plasma that oxygenates or stuffs the titanium nitride layer. The oxygen plasma is maintained for about 30-60 seconds. It is important in the present process that the oxygen is added only after the titanium nitride layer is deposited.

By using a double oxygen deposition, one at the interface between titanium and titanium nitride when the first titanium layer is deposited, and the other at the end of the titanium nitride deposition, spiking does not occur even when an aluminum contact layer is heated up to about 550°C for one hour.

A final Ti wetting layer can be sputter deposited over the oxygenated TiN layer, if desired.

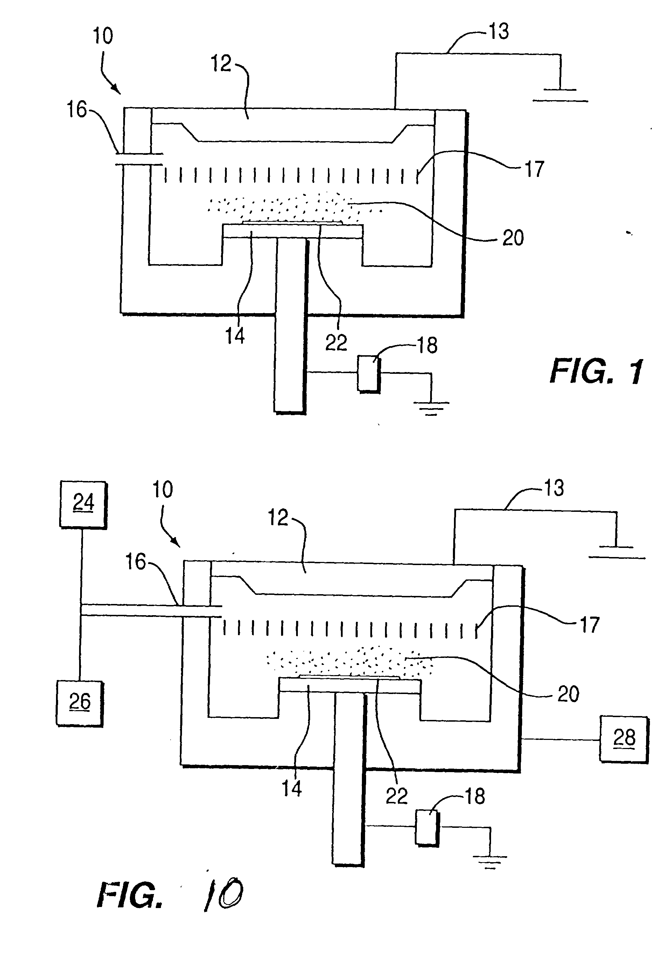

The present process can be carried out in a single sputtering chamber as shown in Fig. 1. A conventional sputtering chamber 10 is modified to add an RF power source 18 to the substrate support 14. In addition a collimator 17 can optionally be mounted in the chamber between the target 12 and the substrate support 14. A suitable collimator 17 contains a plurality of small openings having an aspect ratio of about 1:1. This permits deposition into contact openings having a high aspect ratio. Sputtered particles above the collimator will not pass through these openings unless they travel in a path that passes through the openings in the collimator, i.e., perpendicular to the substrate 22. Thus the sputtered particles that reach the substrate 22 can fill small diameter openings having an aspect ratio of up to about 2:1 without the formation of voids. Since the oxygen-containing layers are thin, the effect of oxygenation on TiN film properties, such as reflectance, stress and crystallinity, are minimal.

Referring still to Fig. 1, a sputtering chamber 10 includes a titanium target 12 connected to a DC power source 13, and a substrate support 14. A collimator 17 is mounted between the target 12 and the substrate support 14. A source of RF power 18 is connected to the substrate support 14 to form a plasma region 20 between the collimator 17 and the substrate support 14. A gas inlet manifold 16 permits various gases to be controllably passed into the chamber. If desired, a second gas inlet can be employed for the oxygen gas to prevent contamination of the other gases, e.g., argon and nitrogen.

To carry out the present deposition process, a substrate is provided having a plurality of exposed openings in which aluminum contacts are to be formed. After mounting the substrate 22 onto the substrate support 14, a flow of argon is started in the chamber, whereupon titanium is sputtered onto the substrate 22. The DC power is adjusted and the RF power is initiated to the substrate support 14 and oxygen is flowed into the chamber, whereupon an oxygen plasma is created in a plasma region 20 above the surface of the substrate 22 and below the collimator 17. The flow of oxygen is stopped, and a flow of argon and nitrogen is begun. Titanium is then sputtered in the presence of nitrogen so that a layer of titanium nitride is deposited over the oxygen-containing titanium layer.

Oxygen is passed again into the chamber and both the DC and the RF power to the substrate support are turned on to form an oxygen plasma that oxygenates or stuffs the titanium nitride layer. The oxygen plasma is maintained for about 30-60 seconds. It is important in the present process that the oxygen is added only after the first titanium layer is deposited and oxygenated, and after the titanium nitride layer is deposited.

By using a double oxygen deposition, one at the interface between titanium and titanium nitride when the first titanium layer is deposited, and the other at the end of the titanium nitride deposition, spiking does not occur even when an aluminum contact layer is heated up to about 550°C for one hour.

Aluminum is deposited thereover, generally in a separate sputtering chamber, to fill the contact openings in the substrate 22. If the aluminum is deposited in the same chamber, the titanium target 12 must be replaced by an aluminum target. However, this method is less preferred since the vacuum in the sputtering chamber must be broken to replace the target. Preferably, the titanium/titanium nitride coated substrate is transferred to a second sputtering chamber to sputter the aluminum.

The titanium is preferably deposited from a nitrided titanium target. The thickness of the sputter-deposited layer of titanium of step a) is preferably from 20 to 50 nm (200 to 500 Å). The thickness of the sputter-deposited layer of titanium nitride of step c) is about 100 nm (1000Å).

The invention will be further described in the following example, but the invention is not meant to be limited to the details described therein.

### Example 1

A barrier/contact stack was made by depositing Ti, oxygenating the Ti with an oxygen plasma, depositing TiN, oxygenating the TiN, depositing a Ti wetting layer and aluminum.

In order to test the contacts, the substrate was heated at 550°C for one hour. The aluminum metal was then stripped off. Any aluminum spiking appears as a shaped feature, particularly one that extends into the substrate.

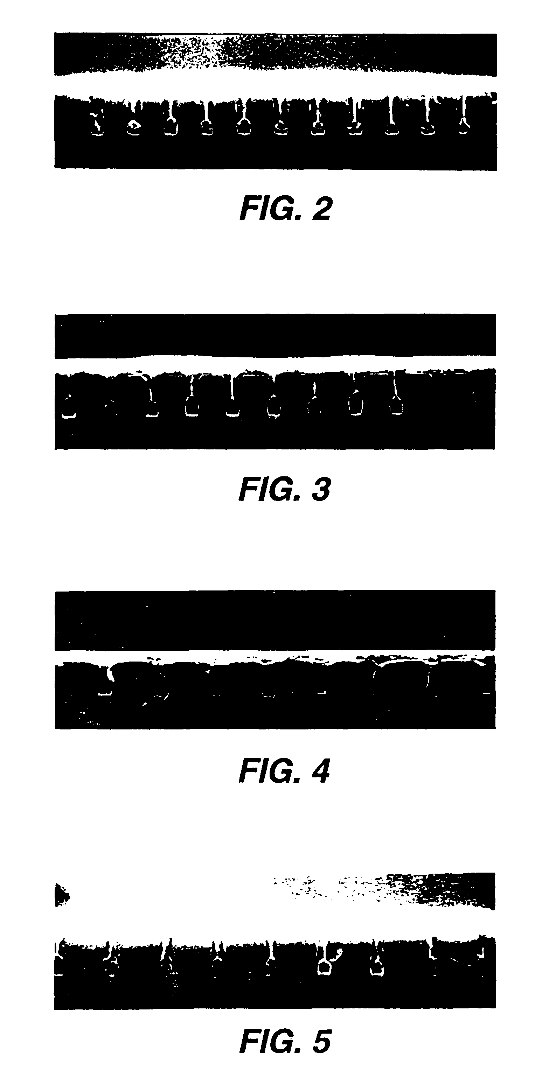

Fig. 2 is a photomicrograph of the deposited stack formed in accordance with the invention after a spike test was conducted. Fig. 2 shows that every opening in the substrate is completely filled and that no spiking occurred in any of the eight contacts shown.

### Control 1

As a first control, a contact comprising a first titanium layer was sputter deposited on a substrate, an overlying titanium nitride layer was formed as above, a third titanium layer was sputter deposited over the titanium nitride layer and a final aluminum layer was deposited. No oxygen was present in the chamber during these depositions. Fig. 3 shows that all of the contacts had spiked through to the substrate.

### Control 2

In a second control, a layer of titanium was deposited followed by deposition of a titanium nitride layer. This titanium nitride layer was exposed to an oxygen plasma after about half of the layer was deposited. A final barrier layer of a thin titanium layer was deposited, followed by deposition of an aluminum layer. Fig. 4 shows that spiking occurred in most of the contacts.

### Control 3

In a third control, a titanium/titanium nitride deposited bilayer was exposed to oxygen plasma after all of the titanium nitride layer was deposited, followed by deposition of the final titanium layer and an aluminum layer. Fig. 5 shows that aluminum spiking occurred through the titanium/titanium nitride/titanium barrier layers.

### Example 2

Using a sputtering chamber as in Fig. 1, a layer of titanium about 200-400Å thick was deposited on a patterned substrate using a DC power of over 10 kilowatts.

An oxygen flow of about 50-100 sccm was started and a plasma formed in the chamber by turning on the DC power and the RF power supply of 100-200 watts. The oxygen treatment was continued for 30 seconds.

The oxygen flow was then turned off and a combined nitrogen and argon flow passed into the chamber. The DC power supply was turned on and from 500-1000Å of TiN was deposited on the substrate. The power was turned off, a flow of oxygen was started again, and both power supplies turned on again to form an oxygen plasma. Treatment of the TiN layer was also continued for 30 seconds.

A final titanium layer about 400-500Å thick was then deposited in the same chamber.

The substrate was transferred to an aluminum sputtering chamber and about 8000-8500Å of aluminum was deposited using the cold/hot process to fill the contact openings.

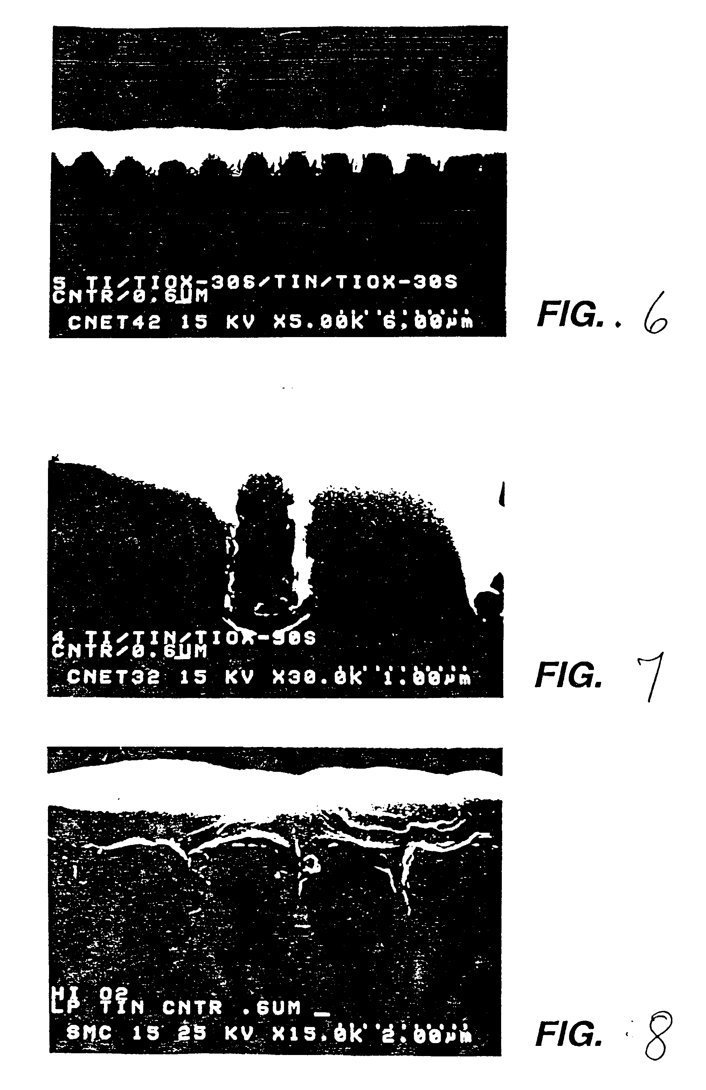

After performing the spike test as in Example 1, no spiking was observed. A series of heat treated aluminum contacts made as above are shown in Fig. 6.

### Control 4

The procedure of Example 2 was repeated except that no oxygen plasma treatment of the first titanium layer was carried out. Spiking was seen for samples annealed at 550°C for one hour as shown in Fig. 7.

### Control 5

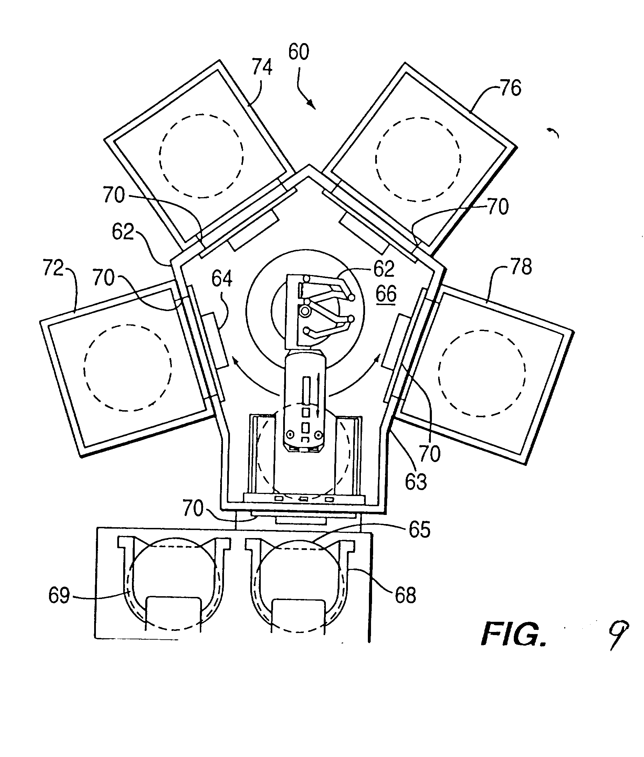

The procedure of Example 2 was repeated except that an oxygen plasma treatment of the first titanium layer was carried out but oxygen plasma treatment of the TiN layer was omitted. Spiking was seen for samples annealed at 550°C for one hour as shown in Fig. 8.

It is believed the oxygen plasma treatment of a titanium layer, followed by deposition of titanium using nitrogen gas, forms an oxygenated titanium layer that can be titanium oxide, or a TiON layer, or a combination thereof. We believe it is the oxygenated titanium layer formed during oxygen plasma treatment that provides improved barrier properties. The amount of oxygen present at the Ti/TiN interface must be sufficient to provide good barrier properties, but not enough to reduce the contact resistance of the contacts. The amount of oxygen can be controlled by adding some oxygen, or oxygen and nitrogen, during the sputter deposition of titanium, and by adding more or less argon during the oxygen plasma treatment to dilute the oxygen. Some nitrogen can also be introduced during the oxygen plasma treatment step to further control the amount of titanium oxide at the Ti/TiN interface. If the titanium oxide layer is deposited to a thickness of no more than about 2 nm (20Å), the sheet resistance of an overlying titanium nitride layer, and the contact resistance, will not be reduced below a desired level.

It is preferred that the deposition of both titanium layers and titanium nitride layers as well as the plasma oxidation steps be carried out in a single deposition chamber for improved throughput. However, if convenient, these steps can be carried out in separate chambers. The total process can be carried out in a multichamber system as described in US Patent 4,951,601 to Maydan et al as shown in Fig. 9. This patent is incorporated herein by reference.

Further, applicants have shown that improved barrier properties for a Ti/TiN stack are obtained when both layers are treated with an oxygen plasma at the end of each deposition.

A computer can be connected to the sputtering chamber as above and can be programmed so as to control the above processes automatically, including adjusting the power supplies, starting and stopping the various gas flows and adjusting the gas flow rates, transferring the substrate into and out of the sputtering chamber and the like. This programmed controller and gas sources are connected to the sputtering chamber as shown in Fig. 10. Fig. 10, in addition to the same parts as shown in Fig. 1, further includes one or more gas sources 24, 26, and a programmed computer 28.

## Claims

1. A process for depositing a titanium/titanium nitride barrier layer in a sputtering chamber fitted with a source of RF power connected to a substrate support, the process comprising:
a) sputter depositing a titanium layer onto the exposed surface of a substrate;
b) oxygenating the titanium layer by treatment with an oxygen-containing plasma in the chamber;
c) sputter depositing a titanium nitride layer over the titanium-oxygen-containing layer; and
d) oxygenating the titanium nitride layer by treatment with an oxygen-containing plasma in the chamber.

2. A process according to claim 1, wherein the oxygen-containing plasma of step b) is formed from a mixture of oxygen and argon.

3. A process according to claim 1 or claim 2, wherein the oxygen-containing plasma of step d) is formed from a mixture of oxygen, argon and nitrogen.

4. A process according to any one of the preceding claims, wherein titanium is deposited from a nitrided titanium target.

5. A process according to any one of the preceding claims, wherein a wetting layer of titanium is deposited over the titanium nitride layer after the oxygen plasma treatment of the titanium nitride layer.

6. A process according to any one of the preceding claims, wherein the substrate has a plurality of openings therein.

7. A process according to claim 6, wherein a layer of aluminium is sputter-deposited over the oxygenated titanium nitride to fill said openings.

8. A process according to any one of the preceding claims, wherein the thickness of the sputter-deposited layer of titanium of step a) is from 20 to 50 nm (200 to 500 Å).

9. A process according to any one of the preceding claims, wherein the thickness of the sputter-deposited layer of titanium nitride of step c) is about 100 nm (1000 Å).

10. A process according to any one of the preceding claims, wherein steps a) to d) are carried out in a single sputtering chamber fitted with a source of RF power connected to the substrate support.

## Patentansprüche

1. Verfahren zur Abscheidung einer Titan/Titannitrid-Sperrschicht in einer Zerstäuberkammer, die mit einer HF-Energiequelle ausgestattet ist, welche mit einem Substratträger verbunden ist, wobei das Verfahren
a) die Zerstäubungsabscheidung einer Titanschicht auf die freiliegende Oberfläche eines Substrats,
b) die Oxidation der Titanschicht durch Behandlung mit einem sauerstoffhaltigen Plasma in der Kammer,
c) die Zerstäubungsabscheidung einer Titannitridschicht auf die Titan und Sauerstoff enthaltende Schicht und
d) die Oxidation der Titannitridschicht durch Behandlung mit einem sauerstoffhaltigen Plasma in der Kammer
umfasst.

2. Verfahren nach Anspruch 1, bei dem das Sauerstoff enthaltende Plasma von Stufe b) aus einem Gemisch aus Sauerstoff und Argon gebildet wird.

3. Verfahren nach Anspruch 1 oder 2, bei dem das Sauerstoff enthaltende Plasma von Stufe d) aus einem Gemisch aus Sauerstoff, Argon und Stickstoff gebildet wird.

4. Verfahren nach einem der vorhergehenden Ansprüche, wobei das Titan aus einem nitrierten Titantarget abgeschieden wird.

5. Verfahren nach einem der vorhergehenden Ansprüche, wobei eine Benetzungsschicht aus Titan auf die Titannitridschicht nach der Sauerstoffplasmabehandlung der Titannitridschicht abgeschieden wird.

6. Verfahren nach einem der vorhergehenden Ansprüche, wobei das Substrat eine Vielzahl von Bohrungen aufweist.

7. Verfahren nach Anspruch 6, bei dem eine Schicht aus Aluminium zur Füllung der Bohrungen auf das oxidierte Titannitrid durch Zerstäubung abgeschieden wird.

8. Verfahren nach einem der vorhergehenden Ansprüche, wobei die Dicke der durch Zerstäubung abgeschiedenen Schicht aus Titan von Stufe a) 20 bis 50 nm (200 bis 500 Å) beträgt.

9. Verfahren nach einem der vorhergehenden Ansprüche, wobei die Dicke der durch Zerstäubung abgeschiedenen Schicht aus Titannitrid von Stufe c) ca. 100 nm (1000 Å) beträgt.

10. Verfahren nach einem der vorhergehenden Ansprüche, wobei die Stufen a) bis d) in einer einzigen Zerstäuberkammer, die mit einer HF-Energiequelle ausgestattet ist, welche mit dem Substratträger verbunden ist, durchgeführt werden.

## Revendications

1. Procédé pour déposer une couche d'arrêt constituée de titane/nitrure de titane dans une chambre de pulvérisation cathodique équipée d'une source de puissance RF connectée à un support de substrat, procédé comprenant les étapes consistant :
a) à déposer par pulvérisation cathodique une couche de titane sur la surface exposée d'un substrat ;
b) à oxygéner la couche de titane par traitement avec un plasma contenant de l'oxygène dans la chambre ;
c) à déposer par pulvérisation cathodique une couche de nitrure de titane sur la couche de titane contenant de l'oxygène ; et
d) à oxygéner la couche de nitrure de titane par traitement avec un plasma contenant de l'oxygène dans la chambre.

2. Procédé suivant la revendication 1, dans lequel le plasma contenant de l'oxygène de l'étape b) est formé à partir d'un mélange d'oxygène et d'argon.

3. Procédé suivant la revendication 1 ou la revendication 2, dans lequel le plasma contenant de l'oxygène de l'étape d) est formé à partir d'un mélange d'oxygène, d'argon et d'azote.

4. Procédé suivant l'une quelconque des revendications précédentes, dans lequel le titane est déposé à partir d'une cible de titane nitruré.

5. Procédé suivant l'une quelconque des revendications précédentes, dans lequel une couche de mouillage de titane est déposée sur la couche de nitrure de titane après le traitement de la couche de nitrure de titane avec un plasma contenant de l'oxygène.

6. Procédé suivant l'une quelconque des revendications précédentes, dans lequel le substrat comporte une pluralité d'orifices.

7. Procédé suivant la revendication 6, dans lequel une couche d'aluminium est déposée par pulvérisation cathodique sur le nitrure de titane oxygéné pour combler les orifices.

8. Procédé suivant l'une quelconque des revendications précédentes, dans lequel l'épaisseur de la couche de titane, déposée par pulvérisation cathodique, de l'étape a) est comprise dans l'intervalle de 20 à 50 nm (200 à 500Å).

9. Procédé suivant l'une quelconque des revendications précédentes, dans lequel l'épaisseur de la couche de nitrure de titane, déposée par pulvérisation cathodique, de l'étape c) est égale à environ 100 nm (1000 Å).

10. Procédé suivant l'une quelconque des revendications précédentes, dans lequel les étapes a) à d) sont mises en oeuvre dans une seule chambre de pulvérisation cathodique équipée d'une source de puissance RF connectée au support de substrat.
